# EUROPÄISCHE PATENTSCHRIFT

(11) **EP 0 833 386 B1**
(45) Veröffentlichungstag und Bekanntmachung des Hinweises auf die Patenterteilung: **04.02.2004**
(21) Anmeldenummer: 97113580.1
(22) Anmeldetag: 05.08.1997
(51) Int. Cl.: H01L 29/417, H01L 29/08, H01L 23/367

(54) **Durch Feldeffekt steuerbares, vertikales Halbleiterbauelement**
Vertical semiconductor device controllable by field effect
Dispositif semiconducteur vertical contrôlable par effet de champ

(30) Priorität: 19.09.1996 DE 19638438
(43) Veröffentlichungstag der Anmeldung: 01.04.1998
(73) Patentinhaber: Infineon Technologies AG, 81669 München (DE)
(72) Erfinder: Tihanyi, Jenö, 85551 Kirchheim (DE)
(74) Vertreter: Patentanwälte Westphal, Mussgnug & Partner

(56) Entgegenhaltungen:
- DE-A- 3 932 621
- US-A- 5 539 238
- KOZO SAKAMOTO ET AL: "AN INTELLIGENT POWER MOSFET WITH REVERSE BATTERY PROTECTION FOR AUTOMATIVE APPLICATIONS" PROCEEDINGS OF THE 8TH. INTERNATIONAL SYMPOSIUM ON POWER SEMICONDUCTOR DEVICES AND IC'S (ISPSD), MAUI, HAWAII, MAY 20 - 23, 1996, Nr. SYMP. 8, 20.Mai 1996, SALAMA C A T;WILLIAMS R K (EDS ), Seiten 57-60, XP000598397

## Beschreibung

Die Erfindung betrifft ein durch Feldeffekt steuerbares Halbleiterbauelement, bestehend aus einem Halbleiterkörper
- mit mindestens einer Drainzone vom ersten Leitungstyp,
- mit mindestens einer Sourcezone vom ersten Leitungstyp,
- mit mindestens.einer Gate-Elektrode, wobei diese gegenüber dem gesamten Halbleiterkörper isoliert ist.
- mit einem Bulkbereich (8) vom ersten Leitungstyp,

Derartige durch Feldeffekt steuerbare Halbleiterbauelemente sind zum Beispiel MOS-Feldeffekttransistoren (MOS-FETs). Diese MOS-FETs sind seit langem bekannt und zum Beispiel im Siemens-Datenbuch 1993/94 SIPMOS-Halbleiter, Leistungstransistoren und Dioden, Seiten 29ff beschrieben. Figur 4 auf Seite 30 dieses Datenbuchs zeigt den prinzipiellen Aufbau eines derartigen Leistungstransistors. Der dort gezeigte Transistor stellt einen vertikalen n-Kanal-SIPMOS-Transistor dar. Bei einem derartigen Transistor dient das n⁺-Substrat als Träger mit der darunterliegenden Drainmetallisierung. Über dem n⁺-Substrat schließt sich eine n⁻-Epitaxieschicht an, die je nach Sperrspannung verschieden dick und entsprechend dotiert ist. Das darüberliegende Gate aus n⁺-Polysilizium ist in isolierendes Siliziumdioxid eingebettet und dient als Implantationsmaske für die p-Wanne und für die n⁺-Sourcezone. Die Sourcemetallisierung überdeckt die gesamte Struktur und schaltet die einzelnen Transistorzellen des Chips parallel. Weitere Einzelheiten dieses vertikal aufgebauten Leistungstransistors sind den Seiten 30ff des obigen Datenbuchs zu entnehmen.

Nachteil einer derartigen Anordnung ist, daß der Durchlaßwiderstand Rₒₙ der Drain-Source-Laststrecke mit zunehmender Spannungsfestigkeit des Halbleiterbauelementes zunimmt, da die Dicke der Epitaxieschicht zunehmen muss. Bei 50 V liegt der flächenbezogene Durchlasswiderstand Rₒₙ bei ungefähr 0,20 Ω mm² und steigt bei einer Sperrspannung von 1000 V beispielsweise auf einen Wert von ca. 10 Ω mm² an.

Im Gegensatz zu lateralen MOSFETs weisen vertikale MOSFETs eine im wesentliche vertikale Stromflussrichtung auf. Das bedeutet, der Strom fließt von der Scheibenvorderseite zur Scheibenrückseite. Bei gattungsgemäßen vertikalen MOSFETs befinden sich die Source- und Gate-Anschlüsse an der Scheibenvorderseite, während der Drain-Anschluss über die Scheibenrückseite kontaktiert wird. Dadurch haben vertikale MOSFETs gegenüber lateralen MOSFETs den Vorteil, dass sie sich platzsparend auf dem Halbleiterchip integrieren lassen, wodurch sich die Bauelemente kostengünstiger fertigen lassen.

Vertikale MOSFETs werden üblicherweise mit der Scheibenrückseite an einem Kühlkörper bzw. am Gerätegehäuse befestigt. Ein Nachteil einer solchen Anordnung besteht darin, dass zwischen dem Drainrückseitenkontakt und dem Kühlkörper, der üblicherweise auf dem Potential der Gerätemasse liegt, eine isolierende Schicht aufgebracht werden muss. Durch die Isolierschicht erhöht sich der Wärmewiderstand zwischen Drainrückseitenkontakt und dem Kühlkörper. Dies führt zu einer geringeren Wärmeableitung über die Scheibenrückseite.

Aus Sakamoto et al: "An Intelligent Power MOSFET with Reverse Battery Protection For Automotive Applications" Proceedings of the 8th. International Symposium On Power Semiconductor Devices and IC's (ISPSD), Maui, Hawaii, May 20 - 23, 1996, Nr. SYMP. 8, 20 Mai 1996, Salama C A T; Williams R K (EDS), Seiten 57-60, ist ein Halbleiterbauelement mit zwei integrierten Leistungs-MOSFET bekannt, wobei der Drain-Anschluss des einen MOSFET und der Source-Anschluss des anderen MOSFET im Bereich einer Vorderseite eines Halbleiterkörpers angeordnet sind, während ein Source-Anschluss des einen Leistungs-MOSFET und ein Drain-Anschluss des anderen Leistungs-MOSFET durch eine gemeinsame Halbleiterzone mit einem gemeinsamen Anschluss im Bereich der Rückseite des Halbleiterkörpers gebildet sind, um dadurch eine Reihenschaltung zweier integrierter Leistungs-MOSFET zu erhalten.

Aus der DE 39 32 621 A1 ist ein MOSFET bekannt, dessen Source-Zone und Drain-Zone im Bereich einer Vorderseite eines Halbleiterkörpers angeordnet sind, wobei sich zwischen der Drain-Zone und der Source-Zone eine gegenüber dem Halbleiterkörper isolierte Gate-Elektrode in einem Graben in den Halbleiterkörper hinein erstreckt und eine implantierte Kanalschicht unterhalb der Gate-Elektrode angeordnet ist.

Aus der US 5, 539,238 ist ein MOSFET bekannt, dessen Source-Zone und Drain-Zone im Bereich der Vorderseite eines Halbleiterkörpers angeordnet sind. Eine Gate-Elektrode befindet sich isoliert gegenüber dem Halbleiterkörper oberhalb der Vorderseite des Halbleiterkörpers. Eine Driftstrecke zwischen der Source-Zone und der Drain-Zone verläuft entlang eines sich in vertikaler Richtung in den Halbleiterkörper hinein erstreckenden Grabens, der mit einem Isolationsmaterial ausgefüllt ist.

Aufgabe der vorliegenden Erfindung ist es, ein durch Feldeffekt steuerbares, vertikales Halbleiterbauelement anzugeben, welches die aufgezeigten Nachteile nicht aufweist.

Diese Aufgabe wird durch den kennzeichnenden Teil: des Anspruchs 1 gelöst. Es ist hier ein durch Feldeffekt steuerba-res Halbleiterbauelement mit dem Source-Anschluss an der Scheibenrückseite angegeben.

In einer Weiterbildung gemäß Patentanspruch 2 und 3 ist der Source-Anschluss an der Scheibenrückseite ohne Isolierschicht direkt auf einem Kühlkörper, insbesondere einem Kupferblock, befestigt. Der Wärmewiderstand zwischen Sourcekontakt und Kühlkörper ist dabei etwa um den Faktor 5 kleiner. Insbesondere durch die sehr gute Wärmeleitfähigkeit von Kupfer wird dadurch eine verbesserte Wärmeabführung über die Scheibenrückseite ermöglicht. Die erfindungsgemäßen Bauelemente lassen sich dadurch weiter miniaturisieren.

Die Patentansprüche 4 bis 6 zeigen Ausgestaltungen der vertikalen MOS-FETs. Für die Vertikalen Trenches wird als leitfähiges Material bevorzugt Titan-Nitrid, hochdotiertes Polysilizium, Metallsilizid oder Metall wegen deren guter Leitfähigkeit verwendet. Der Strom wird dadurch niederohmig von der Scheibenvorderseite zum Sourceanschluß an der Scheibenrückseite geleitet. Wesentlich dabei ist, daß der Bulkbereich ausreichend hoch dotiert ist, um eine niederohmige Verbindung zwischen Scheibenvorderseite und Scheibenrückseite zu gewährleisten.

In einer Weiterbildung gemäß Patentanspruch 7 sind vertikale Zwischenzellenzonen vorgesehen, in denen sich die Gateelektroden und das Gateoxid befinden. Die Gateelektrode wird dabei in den Halbleiterkörper hinein verlagert, wodurch sich vorteilhafterweise MOS-FETs mit hohen Durchbruchspannungen bei gleichzeitig niedrigem Einschaltwiderstand R_{ON} realisieren lassen.

In einer Weiterbildung gemäß Patentanspruch 8 sind unter den Zwischenzellenzonen ionenimplantierte, hochdotierte Kanalzonen vorgesehen. Durch diese sogenannte Kanalimplantation kann die Einsatzspanhung des Kanals des MOS-FETs gezielt eingestellt werden.

Der Patentanspruch 9 ist auf die Kontaktregionen in den Drainzonen gerichtet. Die Kontaktregionen für die Drainanschlüsse müssen eine ausreichend hohe Dotierungskonzentration aufweisen, damit ein ohmscher Kontakt zwischen Halbleiter und Metallisierung gewährleistet ist. Durch Ionenimplantation läßt sich'dabei eine exakt bestimmbare Dotierungsdosis einbringen und damit die gewünschte Dotierungskonzentration in den gewünschten Bereichen einstellen.

Die Ausgestaltung der Gate-Elektrode ist Gegenstand des Patentanspruchs 10. Als Gatematerial wird hier Polysilizium verwendet, da es prozeßtechnisch einfach handhabbar ist und eine gute Leitfähigkeit aufweist.

Pateritanspruch 11 ist auf ein bevorzugtes Herstellungsverfahren des erfindungsgemäßen Halbleiterbauelements gerichtet.

Die Erfindung wird nachfolgend anhand des in der einzigen Figur der Zeichnung dargestellten Ausführungsbeispiels näher erläutert.

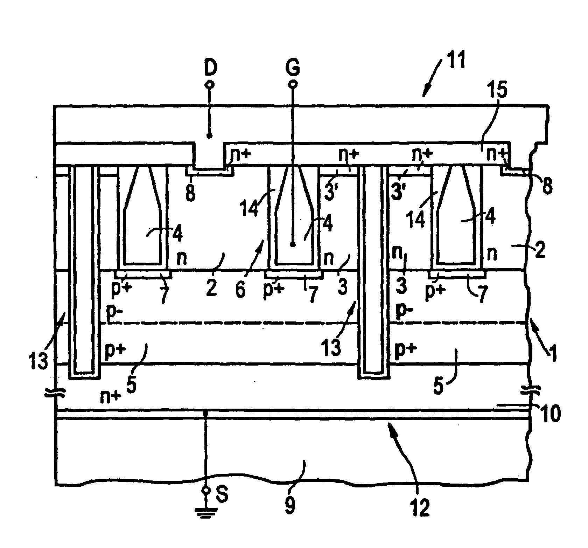

Figur 1 zeigt ein Ausführungsbeispiel der erfindungsgemäßen MOS-FETs mit dem Sourceanschluß an der Scheibenrückseite. Ein Halbleiterkörper 1, beispielsweise eine Siliziumscheibe, ist n⁺-dotiert. Der unbehandelte Halbleiterkörper 1 bildet gleichzeitig die Bulkzone 10. An der Scheibenvorderseite 11 sind auf der Bulkzone 10 nacheinander eine p⁺-dotierte und eine p⁻-dotierte Schicht epitaktisch aufgebracht. Im folgenden werden diese Schichten als Innenzone 5 bezeichnet. Über der Innenzone 5 befinden sich die Drainzonen 2 und Sourcezonen 3, die ebenfalls epitaktisch aufgebracht sind. Die Drainzonen 2 und die Sourcezonen 3 weisen dieselbe Dotierung, im vorliegenden Fall n-Dotierung, auf. Die Dotierungskonzentrationen in den Drainzonen 2 und den Sourcezonen 3 sollten, müssen aber nicht notwendigerweise, gleich sein.

Die Drainzonen 2 und die Sourcezonen 3 sind voneinander beabstandet, wobei jeweils der Abstand zwischen einer Drainzone 2 und einer Sourcezone 3 eine Zwischenzellenzone 6 definiert. Die Zwischenzellenzonen 6 haben die Form von vertikal in den Halbleiterkörper 1 hineinreichenden Gräben. Diese Gräben erstrecken sich von der Scheibenvorderseite 11 des Halbleiterkörpers 1 vertikal über die Drainzone 2 und die Sourcezone 3 hinaus in die Innenzone 5 des Halbleiterkörpers 1. Die Zwischenzellenzonen 6 sollten, müssen aber nicht notwendigerweise, sich bis in die Innenzone 5 erstrecken. Vielmehr ist der Tiefenverlauf frei wählbar.

Die Zwischenzellenzonen 6 enthalten die Gate-Elektroden 4. Die Gate-Elektroden 4 sind mit dem Gateanschluß G verbunden. Als Gate-Material wird wegen seiner prozeßtechnisch einfachen Handhabbarkeit und seiner guten Leitfähigkeit bevorzugt hochdotiertes Polysilizium verwendet. Alternativ kann als Gateoxid auch Titan-Nitrid oder ein Metallsilizid wegen deren guter Leitfähigkeit verwendet werden. Die Gate-Elektroden 4 sind durch ein Gateoxid 14 von den angrenzenden Drainzonen 2 und Sourcezonen 3 bzw. der Innenzone 5 isoliert. Die Gate-Elektroden 4 können je nach Anforderung unterschiedlich ausgestaltet sein. Im vorliegenden Fall haben die Gate-Elektroden 4 die Form einer sich nach oben hin verjüngenden Flasche. Als Gateoxid 14 wird bevorzugt thermisch aufgewachsenes Siliziumdioxid verwendet. Von besonderem Vorteil kann es sein, den Scheitelstrich beziehungsweise Umkehrpunkt der Zwischenzellenzonengräben 6 eher U-förmig auszubilden.

Die Draingebiete weisen eingebettete n⁺-dotierte Gebiete auf und bilden die Kontaktregionen 8. Die Kontaktregionen 8 sind über eine übliche Metallisierung elektrische kontaktiert. Die Gesamtheit der Drainkontakte ist kurzgeschlossen und bildet den Drainanschluß D. Dadurch ist die Vielzahl gleichartiger MOS-FETs parallel geschaltet, wodurch sich die steuerbare Leistung zusätzlich steigern läßt. Die Drainkontakte sind durch ein Zwischenoxid 15 von den Gateanschlüssen G isoliert.

Die Sourcezonen 3 weisen ebenfalls eingebetete n⁺-dotierte Bereiche 3' auf. Erfindungsgemäß sind in die Sourcezonen 3' vertikale Trenches 13 geätzt. Diese vertikalen Trenches 13 enthalten leitfähiges Material, daß mindestens teilweise aus dotiertem Polysilizium, Titannitrid, oder Matall besteht. Die vertikalen Trenches 13 bilden einen Kurzschluß zwischen den n⁺-dotierten Sourcebereichen 3' und der Bulkzone 10.

An der Scheibenrückseite 12 ist die Bulkzone 10 großflächig über eine übliche Metallisierung kontaktiert. Diese Metallisierung bildet den Sourceanschluß S.

Vorteilhafterweise sind unmittelbar unter den Zwischenzellenzonen 6 in der Innenzone 5 p⁺-dotierte Bereiche 7 eingebracht. Diese Bereiche werden im folgenden als Kanalzonen 7 bezeichnet. Der zugrunde liegende Technologieschritt wird allgemein als Kanaldotierung bezeichnet. Bei der Kanaldotierung kann durch Einbringen einer exakt bestimmbaren Dotierungskonzentration die Einsatzspannung für die MOS-FETs genau festgelegt werden. Bei der Kanaldotierung können vorteilhafterweise die geätzten Zwischenzellenzonen 6, bei denen die Gate-Elektrode 4 und das Gateoxid 14 noch nicht eingebracht wurde, als Implantationsmaske verwendet werden. Denkbar ist auch, daß die Kanalzone 7 durch eine dünne, p⁺-dotierte Epitaxieschicht zwischen Innenzone 5 und Drain-/Sourcezonen 2, 3 gebildet wird.

Bei Anlegen einer Gatespannung an die Gate-Elektroden 4 erfolgt der Stromfluß vom Sourceanschluß S an der Scheibenrückseite 12 über die Bulkzone 10 und die vertikalen Trenches 13 zu den n⁺-dotierten Sourcebereichen 3'. Von dort fließt der Strom über den sich ausgebildeten Kanal unter den Zwischenzellenzonen 6 zum Draingebiet 2 und damit zum Drainanschluß D.

An der Scheibenrückseite 12 ist der Sourceanschluß S ohne Isolierschicht auf einem Kühlkörper bzw. Gerätegehäuse 9 befestigt. Das Massepotential der Sourcezone ist damit gleich dem Potential der Gerätemasse. Als Kühlkörper 9 wird bevorzugt ein Kupferblock verwendet. Durch die sehr hohe Wärmeleitfähigkeit von Kupfer wird dadurch eine schnelle Wärmeableitung vom Halbleiterkörper 1 gewährleistet.

Die in Figur 1 gezeigten MOS-FETs werden als selbstsperrende n-Kanal MOS-FETs bezeichnet. Hier sind die Leitungstypen von Drain-/Sourcezone 2, 3 und der Kanalzone 7 unterschiedlich. Selbstverständlich lassen sich die erfindungsgemäßen MOS-FETs auch als selbstleitende Transistoren realisieren. Hierzu muß der Leitungstyp der Kanalzone 7 gleich dem Leitungstyp von Drain-/Sourcezonen 2, 3 sein. Bei diesen selbstleitenden MOSFETs muß die aber Kanalzone 7 die Drain- und Sourcezonen 2, 3 berühren. Sind die Drain-/Sourcezonen 2, 3 p-dotiert und der Bulkbereich n-dotiert, dann lassen sich entsprechend auch p-Kanal-MOSFETs realisieren.

Nachfolgend wird ein mögliches Herstellungsverfahren für die erf indungsgemäßen Leistungs-MOS-FETs entsprechend Figur 2 aufgezeigt. Dabei werden folgende Herstellungsschritte durchgeführt :

Auf den Halbleiterkörper 1, der gleichzeitig die Bulkzone 10 bildet, werden nacheinander die p⁺- und p⁻-dotierten Schichten der Innenzone 5 und die Drain-/Sourcezonen 2, 3 epitaktisch aufgebracht. Die Scheibenvorderseite 11 wird strukturiert und die Kontaktbereiche 8 der Drainzonen 2 und die hochdotierten Sourcebereiche 3' werden durch Ionenimplantation eingebracht. Die Scheibenvorderseite 11 wird erneut strukturiert und die Zwischenzellenzonen 6 werden anisotrop geätzt. Unter Verwendung der vorhandenen Ätzmaske werden die p⁺-dotierten Bereiche 7 in der Innenzone 5 durch Ionenimplantation eingebracht. Anschließend wird eine dünne thermische Siliziumdioxidschicht als Gateoxid 14 in die Zwischenzellenzonen 6 aufgebracht. Die Zwischenzellenzonen 6 werden mit dotiertem Polysilizium als Material für die Gateelektroden 4 aufgefüllt. Überschüssiges Polysilizium wird aus den Zwischenzellenzonen 6 herausgeätzt und die Zwischenzellenzonen 6 werden mit Silizumdioxid aufgefüllt. Die Scheibenvorderseite 11 wird erneut strukturiert und es werden die Trenches 13 anisotrop bis in die Tiefe der Bulkzone 10 geätzt. Auf die Wände der weiteren Trenches 13 wird ein dünnes Oxid aufgebracht und die Trenches 13 werden mit Titannitrid oder dotiertem. Polysilizium aufgefüllt. Der Sourceanschluß S an der Scheibenrückseite 12 wird großflächig metallisiert. Die Scheibenvorderseite 11 wird strukturiert und die Drainanschlüsse D und Gateanschlüsse G werden an den entsprechenden Kontakten metallisiert und voneinander durch ein Zwischenoxid 15 isoliert. Der Sourceanschluß S wird über ein leitfähiges Lot auf einem Kühlkörper 9 befestigt.

Für erfindungsgemäße MOS-FETs mit dem Sourceanschluß an der Scheibenrückseite ergibt sich ein wesentlicher Vorteil: Mit diesen sogenannten Source-Down-Transistoren ist eine im Vergleich zu den Drain-Down-Transistoren verbesserte Verlustleistungsableitung über die Scheibenrückseite, die mit einem Kühlkörper verbunden ist, möglich. Da bei Source-Down-Transistoren zwischen Source-Kontakt und Kühlkörper keine Isolierschicht benötigt wird, ist der Wärmewiderstand etwa um den Faktor 5 geringer. Dadurch lassen sich die entsprechenden Halbleiterbauelemente weiter miniaturisieren.

## Patentansprüche

1. Durch Feldeffekt steuerbares, in einem scheibenförmigen, eine Scheibenvorderseite (11) und eine Scheibenrückseite (12) aufweisenden Halbleiterkörper (1) integriertes Halbleiterbauelement,
- mit mindestens einer Drainzone (2, 8) vom ersten Leistungstyp,
- mit mindestens einer Sourcezone (3, 3') vom ersten Leitungstyp im Bereich der Scheibenvorderseite (11),
- mit mindestens einer Gate-Elektrode (4), wobei diese gegenüber dem gesamten Halbleiterkörper (1) durch ein Gateoxid (14) isoliert ist, wobei sich ein Drainanschluss (D) und ein Gateanschluss (G) an der Scheibenvorderseite (11) befinden,
- mit einem Bulkbereich (10) vom ersten Leitungstyp, der im Bereich der Scheibenrückseite (12) mit einem Sourceanschluss (S) kontaktiert ist,
- mit vertikalen Trenches (13), die mit leitfähigem Material aufgefüllt sind, und die die Sourcezonen (3, 3') an der Scheibenvorderseite (11) und den Bulkbereich (10) des Halbleiterkörpers (1) kurzschließen.

2. Durch Feldeffekt steuerbares Halbleiterbauelement nach Anspruch 1,
**dadurch gekennzeichnet,**
**dass** der Sourceanschluss (S) auf einem Kühlkörper (9) befestigt ist.

3. Durch Feldeffekt steuerbares Halbleiterbauelement nach Anspruch 2,
**dadurch gekennzeichnet,**
**dass** der Kühlkörper (9) ein Kupferblock ist.

4. Durch Feldeffekt steuerbares Halbleiterbauelement nach einem der Ansprüche 1 - 3,
**gekennzeichnet durch** folgendes Merkmal:
- der Bulkbereich (10) des Halbleiterkörpers (1) weist eine sehr hohe Dotierungskonzentration auf.

5. **Durch** Feldeffekt steuerbares Halbleiterbauelement nach Anspruch 1,
**dadurch gekennzeichnet,**
**dass** das leitfähige Material der Trenches (13) Titannitrid oder dotiertes Polysilizium oder Metall enthält.

6. Durch Feldeffekt steuerbares Halbleiterbauelement nach einem der Ansprüche 4 - 5,
**dadurch gekennzeichnet,**
**dass** der Bulkbereich (10) eine Dotierungskonzentration von > 10¹⁸ cm⁻³ aufweist.

7. Durch Feldeffekt steuerbares Halbleiterbauelement nach einem der Ansprüche 1 - 6,
**dadurch gekennzeichnet,**
**dass** Zwischenzellenzonen (6) vorgesehen sind, die die Drainzonen (2, 8) und Sourcezonen (3, 3') beabstanden und in denen sich jeweils eine Gate-Elektrode (4) und das Gateoxid (14) befinden.

8. Durch Feldeffekt steuerbares Halbleiterbauelement nach Anspruch 7,
**dadurch gekennzeichnet,**
**dass** unmittelbar unter den Zwischenzellenzonen (6) jeweils eine Kanalzone (7) vom ersten oder vom zweiten Leitungstyp bevorzugt durch Ionenimplantation eingebracht ist.

9. Durch Feldeffekt steuerbares Halbleiterbauelement nach einem der Ansprüche 1 - 8,
**dadurch gekennzeichnet,**
**dass** in den Drainzonen (2) Kontaktregionen (8) vorgesehen sind, die eine sehr hohe Dotierungskonzentration aufweisen und die bevorzugt durch Ionenimplantation in den Halbleiterkörper (1) eingebracht sind.

10. Durch Feldeffekt steuerbares Halbleiterbauelement nach einem der Ansprüche 1 - 9,
**dadurch gekennzeichnet,**
**dass** das Material der Gate-Elektroden (4) hochdotiertes Polysilizium ist.

11. Verfahren zur Herstellung eines durch Feldeffekt steuerbaren Halbleiterbauelements nach einem der Ansprüche 1 - 10,
wobei die nachfolgenden Verfahrensschritte durchgeführt werden:
- Bereitstellen eines scheibenförmigen, eine Scheibenvorderseite (11) und eine Scheibenrückseite (12) aufweisenden Halbleiterkörpers,
- auf dem Bulkbereich (10) eines Halbleiterkörpers (1) werden die verschiedenen Epitaxieschichten der Innenzone (5) abgeschieden,
- auf der Innenzone (5) wird die Drain-/Sourcezone (2, 3) epitaktisch abgeschieden,
- die Scheibenvorderseite (11) wird strukturiert und die Kontaktregion (8) und die hochdotierten Sourcebereiche (3') werden durch Ionenimplantation eingebracht,
- die Scheibenvorderseite (11) wird erneut strukturiert und die Zwischenzellenzonen (6) werden anisotrop geätzt,
- unter Verwendung der Ätzmaske werden die Kanalzonen (7) durch Ionenimplantation eingebracht,
- unter Verwendung der Ätzmaske wird eine dünne Siliziumdioxidschicht als Gateoxid (14) auf die Grabenwände der Zwischenzellenzonen (6) thermisch aufgebracht, die Zwischenzellenzonen (6) werden mit Polysilizium als Gatematerial aufgefüllt, überschüssiges Polysilizium wird aus den Zwischenzellenzonen (6) herausgeätzt und die Zwischenzellenzonen (6) werden mit Siliziumdioxid als Gatematerial aufgefüllt,
- die Scheibenvorderseite (11) wird wiederum strukturiert und im Bereich der Sourcezonen (3, 3') werden anisotrop die Trenches (13) bis in die Tiefe der Bulkzone (3) geätzt,
- auf die Wände der weiteren Trenches (13) wird ein dünnes Oxid aufgebracht und die weiteren Trenches (13) werden mit leitfähigem Material aufgefüllt,
- an der Scheibenrückseite (12) wird der Sourceanschluss (S) großflächig metallisiert,
- der Drainanschluss (D) und der Gateanschluss (G) an der Scheibenvorderseite (11) werden an den entsprechenden Kontakten metallisiert und voneinander durch ein Zwischenoxid (15) isoliert,
- der Sourceanschluss (S) wird über ein Lot auf dem Kühkörper (9) leitfähig befestigt.

## Claims

1. Field effect-controllable semiconductor component integrated in a wafer-type semiconductor body (1) having a wafer front side (11) and a wafer rear side (12) ,
- having at least one drain zone (2, 8) of the first conduction type,
- having at least one source zone (3, 3') of the first conduction type in the region of the wafer front side (11),
- having at least one gate electrode (4), the latter being insulated from the entire semiconductor body (1) by a gate oxide (14), a drain terminal (D) and a gate terminal (G) being situated at the wafer front side (11),
- having a bulk region (10) of the first conduction type, which is contact-connected to a source terminal (S) in the region of the wafer rear side (12),
- having vertical trenches (13), which are filled with conductive material and which short-circuit the source zones (3, 3') at the wafer front side (11) and the bulk region (10) of the semiconductor (1).

2. Field effect-controllable semiconductor component according to Claim 1,
**characterized**
**in that** the source terminal (S) is fixed on a heat sink (9).

3. Field effect-controllable semiconductor component according to Claim 2,
**characterized**
**in that** heat sink (9) is a copper block.

4. Field effect-controllable semiconductor component according to one of Claims 1 - 3,
**characterized by** the following feature:
- the bulk region (10) of the semiconductor body (1) has a very high doping concentration.

5. Field effect-controllable semiconductor component according to Claim 1,
**characterized**
**in that** the conductive material of the trenches (13) contains titanium nitride or doped polysilicon or metal.

6. Field effect-controllable semiconductor component according to one of Claims 4 - 5,
**characterized**
**in that** the bulk region (10) has a doping concentration of > 10¹⁸ cm⁻³.

7. Field effect-controllable semiconductor component according to one of Claims 1 - 6,
**characterized**
**in that** intermediate cell zones (6) are provided, which space apart the drain zones (2, 8) and source zones (3, 3') and in which are situated in each case a gate electrode (4) and the gate oxide (14).

8. Field effect-controllable semiconductor component according to Claim 7,
**characterized**
**in that** a channel zone (7) of the first or of the second conduction type is in each case introduced directly below the intermediate cell zones (6), preferably by means of ion implantation.

9. Field effect-controllable semiconductor component according to one of Claims 1 - 8,
**characterized**
**in that** contact regions (8) are provided in the drain zones (2) , the said contact regions having a very high doping concentration and preferably being introduced by means of ion implantation into the semiconductor body (1).

10. Field effect-controllable semiconductor component according to one of Claims 1 - 9,
**characterized**
**in that** the material of the gate electrodes (4) is highly doped polysilicon.

11. Method for fabricating a field effect-controllable semiconductor component according to one of Claims 1 - 10,
the method steps below being carried out:
- provision of a wafer-type semiconductor body having a wafer front side (11) and a wafer rear side (12),
- the various epitaxial layers of the inner zone (5) are deposited on the bulk region (10) of a semiconductor body (1),
- the drain/source zone (2, 3) is deposited epitaxially on the inner zone (5),
- the wafer front side (11) is patterned and the contact region (8) and the highly doped source regions (3') are introduced by means of ion implantation.
- the wafer front side (11) is patterned again and the intermediate cell zones (6) are etched anisotropically,
- the channel zones (7) are introduced by means of ion implantation using the etching mask,
- using the etching mask, a thin silicon dioxide layer is applied thermally as gate oxide (14) to the trench walls of the intermediate cell zones (6), the intermediate cell zones (6) are filled with polysilicon as gate material, excess polysilicon is etched out of the intermediate cell zones (6), and the intermediate cell zones (6) are filled with silicon dioxide as gate material,
- the wafer front side (11) is once again patterned and, in the region of the source zones (3, 3'), the trenches (13) are etched anisotropically right into the depth of the bulk zone (3),
- a thin oxide is applied to the walls of the further trenches (13) and the further trenches (13) are filled with conductive material,
- the source terminal (S) is metallized in large-area fashion at the wafer rear side (12),
- the drain terminal (D) and the gate terminal (G) at the wafer front side (11) are metallized at the corresponding contacts and insulated from one another by an intermediate oxide (15),
- the source terminal (S) is fixed conductively on the heat sink (9) by means of a solder.

## Revendications

1. Dispositif à semi-conducteur contrôlable par effet de champ et intégré dans un corps semi-conducteur (1) en forme de disque, comportant une face avant (11) et une face arrière (12) de disque,
- avec au moins une zone de drain (2, 8) appartenant au premier type de conducteur ;
- avec au moins une zone de source (3, 3'), appartenant au premier type de conducteur, au voisinage de la face avant du disque (11) ;
- avec au moins une électrode de grille (4), isolée vis-à-vis de l'ensemble du corps semi-conducteur (1) par un oxyde de grille (14), alors qu'un raccordement de drain (D) et un raccordement de grille (G) se trouvent sur la face avant du disque (11) ;
- avec une zone de charge (10) appartenant au premier type de conducteur et qui est en contact, dans la zone de la face arrière du disque (12), avec un raccordement de source (S) ;
- avec des tranchées verticales (13) remplies de matériau conducteur et qui court-circuitent les zones de source (3, 3') en place sur la face avant (11) du disque, ainsi que la zone de charge (10) du corps semi-conducteur (1).

2. Dispositif à semi-conducteur contrôlable par effet de champ selon la revendication 1,
**caractérisé en ce que**
le raccordement de source (S) est fixé sur un dissipateur thermique (9).

3. Dispositif à semi-conducteur contrôlable par effet de champ selon la revendication 2,
**caractérisé en ce que**
le dissipateur thermique (9) est un bloc de cuivre.

4. Dispositif à semi-conducteur contrôlable par effet de champ selon l'une des revendications 1-3,
**caractérisé en ce que**
la zone de charge (10) du corps semi-conducteur (1) présente une concentration de dopage très élevée.

5. Dispositif à semi-conducteur contrôlable par effet de champ selon la revendication 1,
**caractérisé en ce que**
le matériau conducteur des tranchées (13) contient du nitrure de titane ou du polysilicium dopé ou encore du métal.

6. Dispositif à semi-conducteur contrôlable par effet de champ selon l'une des revendications 4-5,
**caractérisé en ce que**
la zone de charge (10) présente une concentration de dopage supérieure à 10¹⁸ cm⁻³.

7. Dispositif à semi-conducteur contrôlable par effet de champ selon l'une des revendications 1-6,
**caractérisé en ce que**
il est prévu de mettre en place des zones de cellules intermédiaires (6) qui créent une distance entre les zones de drain (2, 8) et les zones de source (3, 3') et dans lesquelles sont placés à chaque fois une électrode de grille (4) et l'oxyde de grille (14).

8. Dispositif à semi-conducteur contrôlable par effet de champ selon la revendication 7,
**caractérisé en ce que**
l'on a mis en place directement en dessous des zones de cellules intermédiaires (6), de préférence par implantation d'ions, à chaque fois une zone de canal (7) appartenant au premier ou au second type de conducteur.

9. Dispositif à semi-conducteur contrôlable par effet de champ selon l'une des revendications 1-8,
**caractérisé en ce que**
dans les zones de drain (2), on a prévu, des régions de contact (8) qui présentent une très haute concentration de dopage et qui ont été mises en place dans le corps semi-conducteur (1) de préférence par implantation d'ions.

10. Dispositif à semi-conducteur contrôlable par effet de champ selon l'une des revendications 1-9,
**caractérisé en ce que**
le matériau des électrodes de grilles (4) est du polysilicium hautement dopé.

11. Procédé de fabrication d'un dispositifs à semi-conducteur contrôlable par effet de champ selon l'une des revendications 1-10, qui consiste à effectuer les opérations suivantes :
- on met au point un corps semi-conducteur en forme de disque, présentant une face avant (11) et une face arrière (12) de disque ;
- dans la zone de charge d'un corps semi-conducteur (1), on sépare les diverses couches épitaxiales de la zone intérieure (5) ;
- dans la zone intérieure (5), on sépare par épitaxie la zone de drain 2 et de source 3 ;
- on structure la face avant (11) du disque et l'on met en place, par l'implantation d'ions, la région de contact (8) et les zones de source hautement dopées (3');
- on structure à nouveau la face avant (11) du disque et l'on décape les zones de cellules intermédiaires (6) de manière anisotrope ;
- en utilisant le masque de décapage, on met en place les zones de canal (7) par implantation d'ions ;
- en utilisant le masque de décapage, on met en place par voie thermique une couche mince de dioxyde de silicium, en tant qu'oxyde de grille (14), sur les parois de tranchée des zones de cellules intermédiaires (6) ; on remplit celles-ci de polysilicium comme matériau de grille, on enlève par décapage le polysilicium en excédent se trouvant dans les zones de cellules intermédiaires (6) et on achève de remplir les cellules (6) avec du dioxyde de silicium comme matériau de grille ;
- on structure à nouveau la face avant (11) du disque et l'on met en place par décapage de manière anisotrope, au voisinage des zones de source (3, 3'), les tranchées (13) jusque dans la profondeur de la zone de charge (3) ;
- on métallise sur une grande surface, sur la face arrière (12) du disque, le raccordement de source (S) ;
- on métallise le raccordement de drain (D) et le raccordement de grille (G) sur la face avant du disque (11) auprès des contacts correspondants et on les isole l'un vis-à-vis de l'autre par un oxyde intermédiaire (15) ;
- on fixe le raccordement de source (S) de manière conductrice sur le dissipateur thermique (9).
